# EUROPEAN PATENT APPLICATION

(11) **EP 0 949 691 A1**
(43) Date of publication of application: **13.10.1999**
(21) Application number: 99400713.6
(22) Date of filing: 23.03.1999
(51) Int. Cl.: H01L 39/22, H01L 39/24

(54) **SQUID formed on a sapphire substrate**

(30) Priority: 23.03.1998 JP 9405798
(71) Applicant: SUMITOMO ELECTRIC INDUSTRIES, LIMITED, Osaka 541 (JP)
(72) Inventor: Nagaishi, Tatsuoki, Itami-shi, Hyogo (JP)
(74) Representative: Portal, Gérard

(57) **Abstract**

The present invention relates to a SQUID made of an oxide superconducting thin film is formed on a sapphire substrate. CeO₂ film, RBa₂Cu₃O₇₋ₓ film ("R" indicates a rare earth element chosen among a group formed Yb, Er, Ho, Y, Dy, Gd, Eu, Sm and Nd) and SrTiO₃ film are deposited the substrate top of sapphire successively. Furthermore, an oxide superconducting thin film to be a SQUID is deposited on the SrTiO₃ film.

## Description

### Detailed description of the Invention

### Field of the Invention

The present invention relates to of SQUID. The present invention is related to a configuration of SQUID and a method for manufacturing the same. More specifically, the present invention is related to a SQUID formed of an oxide superconducting thin film on a sapphire substrate.

### Description of related art

Generally, a SQUID comprises a circular current road for superconducting current, including one or two Josefson conjugation(s). The SQUID related to the present invention is a SQUID formed of an oxide superconducting thin film in particular that has the composition "RBa₂Cu₃O₇₋ₓ ("R" indicates a rare earth element chosen among a group formed Yb, Er, Ho, Y, Dy, Gd, Eu, Sm and Nd)". The oxide superconducting thin film of this kind has high critical temperature and is to be effective by cooling by liquid nitrogen.

However, a specified crystal structure is required so that the oxide thin film obtains superconducting state. Accordingly, in most case, an oxide superconducting thin film is formed on a MgO single crystal substrate or SrTiO₃ single crystal substrate. These substrate materials have well matching of cell to the oxide superconducting thin film and preferable arrangement of crystal is provided.

However, MgO single crystal substrate and SrTiO₃ single crystal substrate are very expensive. And, these substrates having large area are hard to be obtained. As the result, SQUID formed of an oxide superconducting thin film tends to be expensive.

On the other hand, Si single crystal substrate or sapphire substrate is obtained easily and cheep. However, an oxide superconducting thin film is hard to be formed on them.

### Summary of the Invention.

The problems mentioned above will be solved by the present invention. In manufacture method of the present invention, sapphire substrate is used as a substrate material and oxide superconducting thin film of high quality is formed at the same time.

Characteristic of the present invention is not simple displacement of substrate material. Namely, when a SrTiO₃ film is formed directly on a sapphire substrate, SrTiO₃ film (100) is never formed. However, the method according to the present invention contains peculiar characteristic 3 phases production process.

As the first process, a CeO₂ (100) film is formed on the sapphire substrate. As the second process forms, a RBa₂Cu₃O₇₋ₓ (001) film ("R" indicates a rare earth element chosen among a group formed Yb, Er, Ho, Y, Dy, Gd, Eu, Sm and Nd) is formed on the CeO₂ (100) film. As the third process, SrTiO₃ (100) film is formed on the RBa₂Cu₃O_{7-X} (001) film. At last, the oxide superconducting thin film to be a SQUID is formed on this SrTiO₃ (100) film.

Such processes bring the following effect.

Each film sticks well mutually. The oxide superconducting thin film can be formed on SrTiO₃ film that is oriented (100). Accordingly, high quality oxide superconducting thin film is provided on a sapphire substrate. The quality of the oxide superconducting thin film is equal to the one of an oxide superconducting thin film on MgO substrate or SrTiO₃ substrate. Acquisition of a sapphire substrate is easy, different from MgO substrate or SrTiO₃ plate.

Furthermore, an advantage is not simply confined to reduction of material cost. A sapphire substrate having large area is easy to provided. Accordingly, several SQUIDs can be formed on one substrate and production of SQUID becomes in large quantities.

In other words, high performance and inexpensive SQUID is to be supplied by the present invention.

The above and other objects, features and advantages of the present invention will be apparent from the following description of preferred embodiments of the invention with reference to the accompanying drawings.

### Brief Description of the Drawings

Figure 1 shows diagrammatic sectional views for illustrating each process of the method of the present invention.

Figure 2 shows a birdseye view of one of embodiments of the present invention.

### Description of the Preferred embodiments

### Embodiment 1

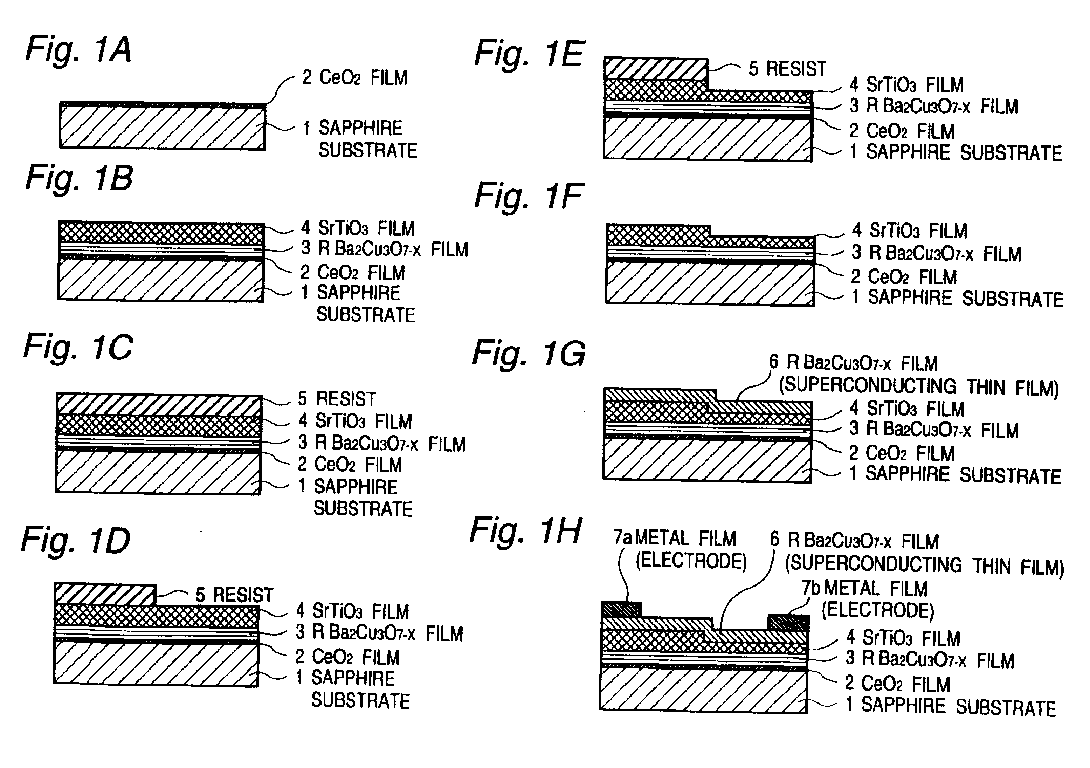

At first, as shown in Figure 1A, CeO₂ film 2 is deposited the whole surface of the sapphire substrate 1 having a flat R principal surface. As shown in Figure 1B, a RBa₂Cu₃O₇₋ₓ ("R" indicates a rare earth element chosen among a group formed Yb, Er, Ho, Y, Dy, Gd, Eu, Sm and Nd) film 3 and a SrTiO₃ film 4 deposited on the CeO₂ film 2 successively. Each process of these series processes can be done by pulsed laser deposition for example.

Successively, the surface of the SrTiO₃ film is processed to form a physical step by the following process.

At first, as shown in Figure 1C, resist 5 is deposited on the whole surface of the SrTiO₃ film 4. Successively, as shown in Figure 1D, after a part of this resist has exposed, unnecessary domain of the resist is removed. As shown in Figure 1E, the resist 5 left is used as a mask while a part of the SrTiO₃ film 4 is removed by Ar ion-milling. Finally, as shown in Figure 1F, the resist layer 5 left on the SrTiO₃ film 4 is removed with appropriate solvent. A kind of solvent is selected according to a kind of resist, for example, a solvent can be an acetone.

Then, after series of the process, a physical step is formed on the surface of the SrTiO₃ film 4. This SrTiO₃ film 4 becomes a substrate of an oxide superconducting thin film.

As shown in Figure 1G, an oxide superconducting thin film 6 is deposited on the SrTiO₃ film 4. This oxide superconducting thin film 6 has a composition RBa₂Cu₃O₇₋ₓ. ("R" indicates a rare earth element chosen among a group formed Yb, Er, Ho, Y, Dy, Gd, Eu, Sm and Nd)

Furthermore, as shown in Figure 1H, a pair of electrode 7a, 7b is formed on the oxide superconducting thin film 6. The electrode 7a, 7b is formed by using a metal mask for example and formed of Au membrane and Ag membrane laminating each other for example.

Finally, the oxide superconducting thin film 6 is processed precision at the point as same as the step. The oxide superconducting thin film processed forms a Josefson junction. This minute processing can be enforced by standard photolithography technology.

Thus, the process of manufacturing the SQUID has completed in this way. Orientation of each film is shown in Table 1.

**Table 1**

| | | |
|---|---|---|
| CeO₂ | RBa₂Cu₃O₇₋ₓ | SrTiO₃ |
| (100) | (001) | (100) |

We made a SQUID actually by the method mentioned above. Deposition of each film was done by laser beam vapor deposition. Common condition is shown in Table 2 and individual condition is shown in Table 3.

**Table 2**

| | |
|---|---|
| Substrate and distance of target | 100 mm |
| Energy density of laser beam | 2.5 J/cm² |
| Exposure area | 2 mm X 4 mm |

**Table 3**

| | | | |
|---|---|---|---|
| Composition of film | CeO₂ | RBa₂Cu₃O₇₋ₓ | SrTiO₃ |
| temperature of substrate (°C) | 680 | 700 | 700 |
| oxygen pressure (mTorr) | 10 | 400 | 100 |
| film thickness (nm) | 20 | 100 | 300 |

It was identified by a test that the condition mentioned above is effective when any chemical element is selected as an element "R". ("R" indicates a rare earth element chosen among a group formed Yb, Er, Ho, Y, Dy, Gd, Eu, Sm and Nd)

The height of the step formed on the SrTiO₃ film was 160nm. Thickness of the oxide superconducting thin film was 220nm. The width of the superconducting thin film at the Josefson junction was 5 µm. The configuration of SQUID was 5 mm square. The inductance of SQUID was turned into 40pH.

Current/voltage characteristic and magnetic field/voltage characteristic of this SQUID provided were measured by quadrupole method. As a result, 2Ic was 100 µA, and current potential characteristic of RSJ type was observed. These results mean that the conjugation is good condition. Furthermore, width of voltage modulation by having hanged magnetic field was more than 10 µV.

Then, we understood that the SQUID formed on the sapphire substrate worked as a magnetism sensor and confirmed good characteristic of the SQUID from these resultant.

### Embodiment 2

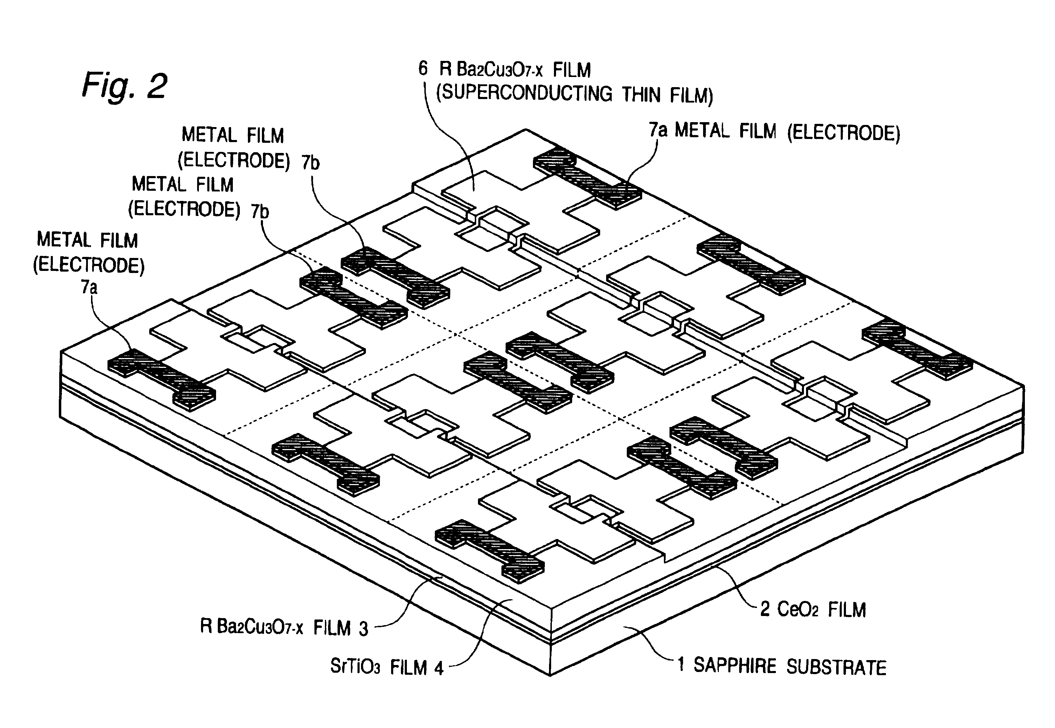

Sapphire substrate having large sapphire is ordinary supplied. Accordingly, in case that sapphire substrate is used as a substrate for SQUID, as shown in Figure 2, several SQUID can be put on one substrate 1. In this case, manufacture time for one SQUID is shortened.
Dimension of each element drawn in Figure 2 is exaggerated so that characteristic of each element is easy to be understood. At the same time, in Figure 2, the reference number given for each element is the same as one corresponding in Figure 1.

## Claims

1. A method for manufacturing a SQUID formed of oxide superconducting thin film comprising following each processes;
(1) CeO₂ film, RBa₂Cu₃O₇₋ₓ film and SrTiO₃ film are deposited on a sapphire substrate in sequence, ("R" indicates a rare earth element chosen among a group formed Yb, Er, Ho, Y, Dy, Gd, Eu, Sm and Nd)
(2) A physical step is formed on said SrTiO₃ film,
(3) A second RBa₂Cu₃O₇₋ₓ film is formed on said SrTiO₃ film, ("R" indicates as same as the above) and
(4) An oxide superconducting thin film is patronized to be a SQUID.

2. A method mentioned in claim 1, said CeO₂ film is a CeO₂ film oriented (100), said RBa₂Cu₃O₇₋ₓ film is a RBa₂Cu₃O₇₋ₓ film oriented (001) ("R" indicates as same as the above) and said SrTiO₃ film is a SrTiO₃ film oriented (100).

3. A method mentioned in claim 2, said CeO₂ film is deposited by a laser beam vapor deposition method in an atmosphere less than 50 m Torr.

4. A method mentioned in claim 3, said SrTiO₃ film is deposited by a laser beam vapor deposition method in an atmosphere less than 50 m Torr.

5. A method mentioned in claim 1, several SQUIDs are formed on one sapphire substrate simultaneously.

6. A SQUID formed of oxide superconducting thin film comprising; a sapphire substrate, a CeO₂ film, a RBa₂Cu₃O₇₋ₓ film and a SrTiO₃ film repeated on said sapphire substrate and a second RBa₂Cu₃O₇₋ₓ film ("R" indicates a rare earth element chosen among a group formed Yb, Er, Ho, Y, Dy, Gd, Eu, Sm and Nd) that is an oxide superconducting thin film and formed to be a SQUID.

7. A SQUID mentioned in claim 6, said CeO₂ film is a CeO₂ film oriented (100), said RBa₂Cu₃O₇₋ₓ film is a RBa₂Cu₃O₇₋ₓ film oriented (001) ("R" indicates as same as the above) and said SrTiO₃ film is a SrTiO₃ film oriented (100).
